# EUROPEAN PATENT APPLICATION

(11) **EP 4 254 702 A1**
(43) Date of publication of application: **04.10.2023**
(21) Application number: 22166098.8
(22) Date of filing: 31.03.2022
(51) Int. Cl.: H02H 9/04, G01R 19/25, H02H 3/04

(54) **DEVICE AND METHOD FOR PROTECTING A MEASUREMENT CIRCUIT**

(71) Applicant: Hitachi Energy Switzerland AG, 5400 Baden (CH)
(72) Inventor: KRISTIANSSON, Johan Emil, 117 71 Stockholm (SE); BARKENSJÖ, Pär, 771 30 Ludvika (SE); KVIST, Anders, 172 22 Sundbyberg (SE); SIKSTRÖM, Martin, 172 22 Sundbyberg (SE)
(74) Representative: Valea AB

(57) **Abstract**

A device (20) comprising a suppression unit (10) and a measurement circuit (24), wherein the suppression unit (10) comprises at least one parallel connected protection branch (30) connected between a surge arrester (28) and ground. The at least one protection branch (30) comprises at least one TVS device (12) and may comprise at least one impedance (14), connected in series with the at least one TVS device (12). The suppression unit (10) is configured to divert leakage current through the measurement circuit (24) and bypass the measurement circuit (24) and lead surge current to ground, during a surge event to protect the measurement circuit (24).

## Description

### FIELD OF THE INVENTION

The invention relates to the field of surge arrester monitoring devices. In particular the invention relates to handling protection of a measurement circuit.

### BACKGROUND

Overvoltage events caused by lightning strikes, switching operations or temporary surges, can result in power outages in power stations, substations, and electric power transmission and distribution lines. Surge arresters, which are configured to have a high impedance at normal operating voltage and a low impedance during a surge event, are usually installed between phase and ground to provide protection from excessive overvoltage caused by such overvoltage events. When the voltage across the surge arrester terminals exceeds a predetermined threshold voltage, the surge arrester conducts the current caused by the overvoltage to the ground.

The condition of a surge arrester can be monitored by measuring the leakage current through the ground conductor at the grounded side of a surge arrester. The total leakage current of a surge arrester is composed of a capacitive component and a resistive component, whereby the capacitive component is much larger than the resistive component. An increase in the resistive current, and consequently the total leakage current, indicates that the condition of the surge arrester has degraded.

A number of measurement methods have been utilized to reveal signs of deterioration and provide clues to impending surge arrester failure. Many of these measurements utilize sensitive leakage current measurement circuitry that can measure small changes in the total leakage current. When making such measurements, it is essential to protect the sensitive measurement circuitry against overcurrent to which a surge arrester may be exposed during surge events.

One known method to measure the leakage current is a standard pass-through solution in which a solid aluminium conductor carrying a primary current is passed through a toroidal core conversion circuit to generate a secondary current that is picked up by a leakage current measurement circuit. Conventional diodes are then used to rectify the secondary current signal. A problem with this approach is that very small secondary currents are generated in the toroidal core's secondary winding so passive electronics and cost-effective analog meters cannot be used to measure those small currents. Instead, active electronics with digital displays must be used to measure the leakage current through the conductor, which increase the cost and complexity of the leakage current measurement device.

Another known method is to use a circuit comprising a metal oxide (MO) block to divert the leakage current to a measurement circuit. A drawback of this method is that the MO block must be selected to match the characteristics of the surge arrestor whose leakage current is being measured (and which also contains MO blocks) and the process of assembling such a measurement circuit is complex.

It is also known to use a spark gap to divert the leakage current to a measurement circuit. Drawbacks with this method are the difficulties involved in providing a specific gap distance between electrodes and ensuring a safe failure mode. A very rigid housing is needed so that the spark gap distance is always accurately controlled, and there may be problems concerning the aging of the spark gap and fluctuations of the spark gap characteristics due to climate and environmental conditions, such as humidity, temperature or altitude.

The present disclosure presents an improved viable solution of a device that handles the issues described above and provides protection for electronic circuits that enable surge arrester monitoring devices to operate without interruption during all system events of a transmission network.

### SUMMARY

It is an object of embodiments herein to provide an improved device that handles protection of a measurement circuit in an efficient manner, or at least to achieve an alternative to known solutions within the technical field.

According to an aspect the object is achieved by providing a device comprising a suppression unit and a measurement circuit. The suppression unit comprises at least one parallel connected protection branch connected between a surge arrester and ground. The at least one protection branch comprises at least one transient voltage suppression (TVS) device. The suppression unit is configured to divert leakage current through the measurement circuit and bypass the measurement circuit and lead surge current to ground during a surge event. The at least one parallel connected protection branch is configured to protect the measurement circuit.

According to another aspect the above-mentioned object is also achieved by providing a method for protecting a measurement circuit. The method comprises the step of providing a device comprising a suppression unit and the measurement circuit. The suppression unit comprises at least one parallel connected protection branch connected between a surge arrester and ground. The at least one protection branch comprises at least one TVS device. The suppression unit diverts leakage current through the measurement circuit and bypasses the measurement circuit and leads surge current to ground during a surge event to protect the measurement circuit.

Embodiments herein are based on the realisation that by bypassing the measurement circuit and leading surge current via the at least one parallel connected protection branch to ground during a surge event, the measurement circuit can be protected against overcurrent. Thereby protection of the measuring circuit is handled in an efficient manner.

### BRIEF DESCRIPTION OF THE FIGURES

Further technical features of the invention will become apparent through the following description of one or several exemplary embodiments given with reference to the appended figures, where:
- Fig. 1: shows a device according to embodiments herein;
- Fig. 2: shows a device according to some embodiments herein; and
- Fig. 3: is a flow chart showing a method for protecting a measurement circuit according to embodiments herein.

It should be noted that the drawings have not necessarily been drawn to scale and that the dimensions of certain elements may have been exaggerated for the sake of clarity.

### DETAILED DESCRIPTION

Embodiments herein relate to a device, e.g. comprising a solid-state protection circuit, for surge arrester monitoring devices. The embodiments herein provide protection for electronic circuits that enable surge arrester monitoring devices to operate without interruption during all system events of a transmission network, i.e. normal operation, surge events and earth fault events. Previous solutions using a current conductor to insulate the earth conductor from the measurement circuit, have some limitations with e.g. a limited amount of energy that could be transferred to the measurement circuit. Therefore, in the previous solutions, active electronics with digital displays were used to enable measurement of the leakage current through the conductor. With the current solution according to embodiments herein full leakage current is diverted into a measurement circuit and thus the available energy is greater, enabling the use of cost-effective analog meters and passive electronics. At the same time the protection circuit will protect the circuitry against overcurrent.

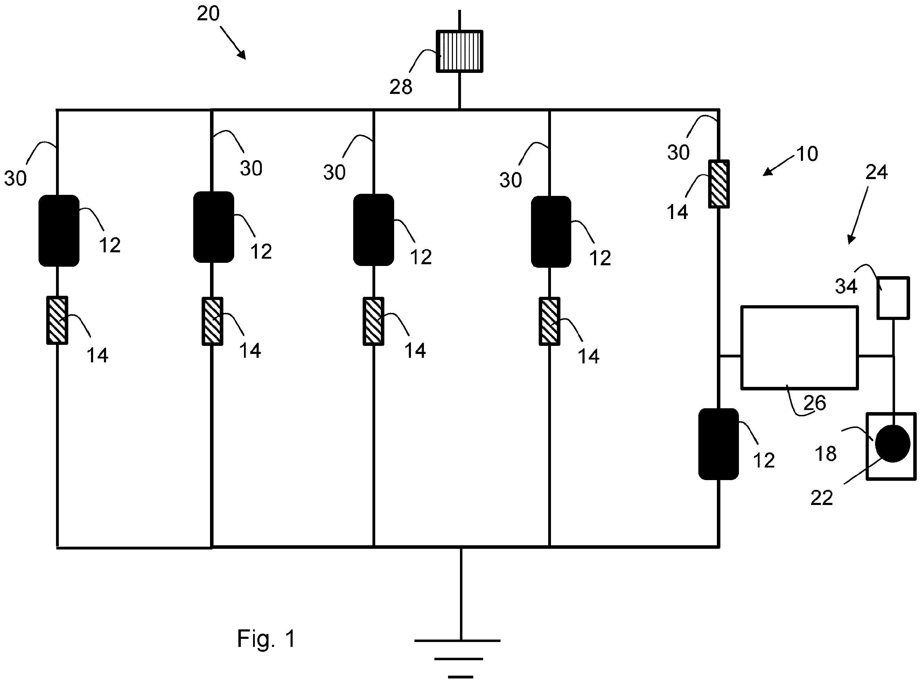

A device 20 according to embodiments herein is illustrated in Fig. 1. The device 20 comprises a suppression unit 10 and a measurement circuit 24, wherein the suppression unit 10 comprises one or more parallel connected protection branch 30 connected between a surge arrester 28 and ground. Fig. 1. illustrates an exemplary configuration with five parallelly connected protection branch 30. Each protection branch 30 comprises at least one TVS device 12 and may comprise at least one impedance 14, connected in series with the at least one TVS device 12. The at least one TVS device 12 may be a TVS diode and the at least one impedance 14 may be a resistor. The impedance 14, at least in the protection branch that has the TVS device 12 connected in parallel with the measurement circuit 24 and other circuitries as may be in specific configurations, in a preferred embodiment the TVS device 12 in a protection branch 30, is connected at the ground side i.e. one of the terminals of the TVS device 12 is grounded and the other terminal of the TVS device 12 may be connected to the series connected impedance 14. The TVS device 12 may operate by shunting excess current when the induced voltage exceeds the avalanche breakdown potential. The TVS device 12 may suppresses all overvoltage above its breakdown voltage. It automatically goes back to its normal state when the overvoltage has passed. That the at least one parallel connected protection branch 30 comprises at least one TVS device 12 and may comprise at least one impedance 14 is advantageous because it provides a controlled, fast and predetermined protection to the measurement circuit 24, and is laid out, e.g. assembled, such that the surge current is uniformly distributed in the parallel connected protection branches 30. In addition, the device is easy to assemble and the assembly process can be automated reducing cost and improving repeatability of performance (controlled, fast and predetermined protection) of the device. The number of parallel branches and the value of impedances 14 to be used depends on the electrical characteristics of the suppression unit i.e. to have sufficient parallel branch to reliably conduct the surge current and at the same time to ensure that the voltage drop across the impedance is low but sufficient enough to make the difference in TVS device characteristics insignificant in the parallel branches to have even distribution of surge current in the branches. The impedance in addition also helps in reducing the difference in the lead and current path inductances in the one or more parallel branches.

During normal leakage current operation, i.e. during normal operation of the surge arrester and the leakage current is to be measured, e.g. when the surge arrester 28 has high impedance, e.g. resistance, at normal operating voltage, the suppression unit 10 has a very high impedance and is thus configured to divert leakage current through the measurement circuit 24 to ground. This enables full use of the energy contained within that leakage current. This further enables the device to drive loads. e.g. an analog meter, compared to using a pass-through conductor design with active electronics as in the priorart solutions. Leakage current, when used herein, may be defined as the current flowing in the earth conductor between the surge arrester and ground during normal operating voltage of the system.

During a surge event, i.e. when an overvoltage is present across the surge arrester and the resulting impedance of the surge arrester is low, the suppression unit 10 is configured to bypass the measurement circuit 24 and lead, e.g. transfer, surge current via the at least one parallel connected protection branch 30 to ground. The surge event may e.g. be lightning, switching, or temporary overvoltage events. According to some embodiments, the suppression unit 10 may change its behaviour from non-conductive to conductive during the surge event and may thus bypass the measurement circuit 24 to ground. The at least one parallel connected protection branch 30 is thereby configured to effectively protect the measurement circuit 24 against overcurrent that would otherwise damage the circuit. Surge current, when used herein, may be defined as the current through the surge arrester resulting from any of the abovementioned surge events.

According to some embodiments the measurement circuit 24 comprises a leakage current measurement circuit 18 configured to measure the leakage current. According to some embodiments the leakage current measurement circuit 18 comprises a measuring indication unit 22 configured to indicate or display the leakage current. According to some embodiments the measurement circuit 24 comprises a surge counting circuit 34 configured to count surges. The surge counting circuit 34 may thus be configured to register, and optionally display, surges. According to some embodiments the measurement circuit 24 comprises a conversion circuit 26. The conversion circuit 26 may be configured to convert an alternating current (AC) to a direct current (DC) and supply said DC to power the leakage current measurement circuit 18.

Accordingly, embodiments herein concern a device 20 that comprises the suppression unit 10 and the measurement circuit 24 and solves the problem of getting energy to the measurement circuit 24 whilst protecting the same from excessive overcurrent during surge events, e.g. system fault events.

As mentioned above, the suppression unit 10 comprises the at least one connected protection branch 30 connected between the surge arrester 28 and ground, wherein the at least one connected protection branch 30 comprises one or more TVS device 12 connected in series and/or parallel combinations and may comprise one or more impedance 14 connected in series with the one or more TVS device 12. The number of TVS devices 12 to be used may depend on the rating of each TVS device 12 and on the maximum discharge current that the TVS device 12 needs to handle. As the TVS device 12 has a certain variation in its characteristics the one or more series connected impedance 14 may enable an even current sharing between the at least one TVS device 12 during a discharge event, e.g. a surge event. If a plurality of TVS devices 12 have a sufficiently low spread of their characteristics or if only one TVS device 12 is used, then the impedances 14 may be eliminated. The number of parallel connected protection branches 30 to be used may depend on the characteristics of the TVS and the characteristics of the surge arrester to which the device is to be connected, e.g. surge current, charge, etc. To have more than one parallel connected protection branch 30 is advantageous as it allows for the device 20 to be designed that can accommodate surge arrester with considerably higher characteristics, e.g. surge current, charge, etc, than what a single protection branch can support.

According to some embodiments the measurement circuit 24 comprises a surge counting circuit 34 configured to count surges i.e. by counting the voltage drop found during the conduction of the TVS device. According to some embodiments the surge counting circuit 34 and the leakage current measurement circuit 18 are connected across the one or more TVS device 12. Connection of the surge counting circuit 34 and the leakage current measurement circuit 18 may be made to separate TVS devices 12 in the one or more protection branches 30 to decouple surge counting circuitry with the leakage current measurement in the measurement circuit 24. Such a configuration would improve balancing and accuracy of surge count and leakage measurement.

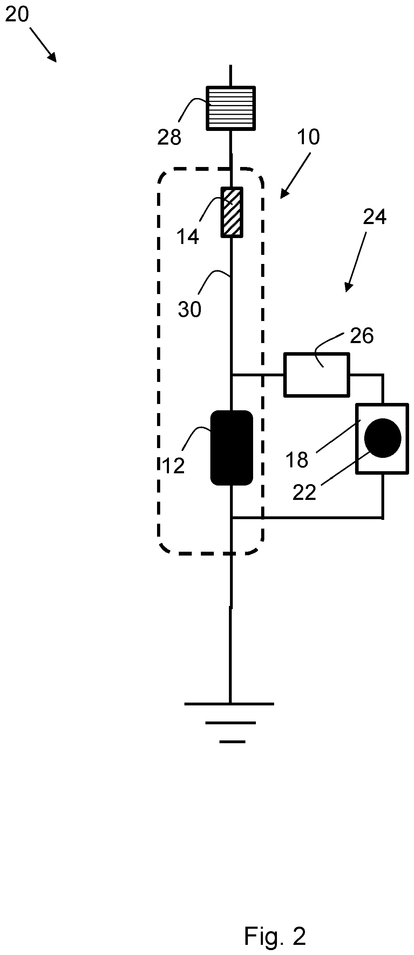

In **Fig. 2****,** the device 20 is illustrated according to some embodiments. The device 20 comprises a suppression unit 10 and a measurement circuit 24, wherein the suppression unit 10 comprises only one protection branch 30, i.e. at least one parallel connected protection branch 30, connected between the surge arrester 28 and ground. The at least one protection branch 30 comprises at least one TVS device 12 and may comprise at least one impedance 14, connected in series with the at least one TVS device 12. The suppression unit 10 is illustrated with dashed lines, to make the figure clearer. The at least one TVS device 12 may be a TVS diode and the at least one impedance 14 may be a resistor. The suppression unit 10 is configured to divert leakage current through the measurement circuit 24 and bypass the measurement circuit 24 and lead surge current via the at least one parallel connected protection branch 30 to ground, during a surge event. The at least one parallel connected protection branch 30 is thereby configured to protect the measurement circuit 24 with the TVS device 12. According to some embodiments the measurement circuit 24 comprises a leakage current measurement circuit 18 configured to measure the leakage current. According to some embodiments the leakage current measurement circuit 18 comprises a measuring indication unit 22 configured to indicate, e.g. display, the leakage current. According to some embodiments the measurement circuit 24 comprises a conversion circuit 26. The conversion circuit 26 may be configured to convert an AC to a DC and supply said DC to the leakage current measurement circuit 18. According to some embodiments the suppression unit 10 changes its behaviour from non-conductive to conductive during the surge event.

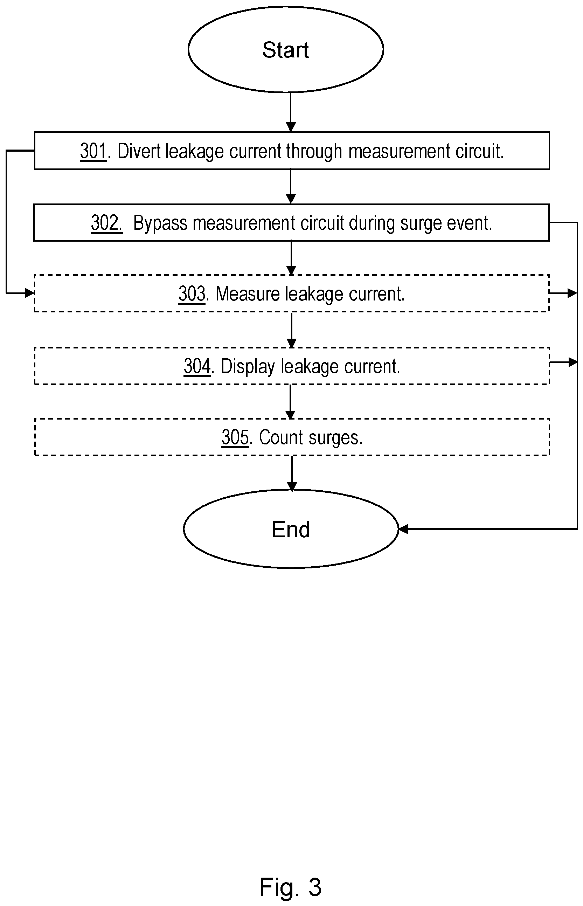

The method actions for protecting the measurement circuit 24, according to embodiments herein, will now be described with reference to a flowchart depicted in Fig. 3. The actions do not have to be taken in the order stated below but may be taken in any suitable order. Actions performed in some embodiments are marked with dashed boxes. The method comprises the action of providing the device 20, which device comprises the suppression unit 10 and the measurement circuit 24. The suppression unit 10 comprises the at least one parallel connected protection branch 30 connected between the surge arrester 28 and ground.

### Action 301.

The at least one protection branch 30 comprises at least one TVS device 12 and may also comprise at least one impedance 14, e.g. a resistor, connected in series with the at least one TVS device 12. The at least one TVS device 12 may be a TVS diode. During normal operation of the surge arrester 28, e.g. during a non-surge event, the suppression unit 10 diverts the leakage current through the measurement circuit 24.

### Action 302.

During a surge event, the suppression unit 10 bypasses the measurement circuit 24 and leads the surge current via the at least one parallel connected protection branch 30 to ground. The at least one parallel connected protection branch 30 is configured to protect the measurement circuit 24. According to some embodiments, the suppression unit 10 changes its behaviour from non-conductive to conductive during the surge event.

### Action 303.

The measurement circuit 24 may comprise the leakage current measurement circuit 18. The leakage current measurement circuit 18 may be used to measure the leakage current. The measurement circuit 24 may also comprise a conversion circuit 26 which may be used to convert an AC to a DC and supply said DC to the leakage current measurement circuit 18.

### Action 304.

The leakage current measuring circuit 18 may comprise a measuring indication unit 22. The measuring indication unit 22 may be used to indicate, e.g. display, the leakage current, e.g. with an analog meter.

### Action 305.

The measurement circuit may further comprise a surge counting circuit 34 which may comprise counting surges. The surge counting circuit 34 and the leakage current measurement circuit 18 may be connected across one or more TVS device 12, e.g. using resistive dividers. Such a configuration improves balancing and accuracy of the surge counting and the leakage current measurement.

It is to be noted that any feature of any of the aspects may be applied to any other aspect, wherever appropriate. Likewise, any advantage of any of the aspects may apply to any of the other aspects.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated. The use of "first", "second" etc. for different features/components of the present disclosure are only intended to distinguish the features/components from other similar features/components and not to impart any order or hierarchy to the features/components.

It will be appreciated that the foregoing description and the accompanying drawings represent non-limiting examples of the method and arrangement taught herein. As such, the arrangement and techniques taught herein are not limited by the foregoing description and accompanying drawings. Instead, the embodiments herein are limited only by the following claims and their legal equivalents.

## Claims

1. A device (20) comprising a suppression unit (10) and a measurement circuit (24) connected in parallel to the suppression unit, wherein the suppression unit (10) comprises at least one parallel connected protection branch (30) connected between a surge arrester (28) and ground, wherein the at least one protection branch (30) comprises at least one transient voltage suppression, TVS, device (12), and wherein the suppression unit (10) is configured to:
- divert leakage current from the surge arrester (28) through the measurement circuit (24); and
- bypass the measurement circuit (24) and lead surge current to ground during a surge event to protect the measurement circuit (24).

2. The device (20) according to claim 1, wherein the TVS device (12) is a TVS diode.

3. The device (20) according to claim 1 or 2, wherein the at least one protection branch (30) further comprises an impedance (14) connected in series with the at least one TVS device (12).

4. The device (20) according to any one of claims 1-3, wherein the measurement circuit (24) comprises a leakage current measurement circuit (18) configured to measure the leakage current.

5. The device (20) according to claim 4, wherein the leakage current measurement circuit (18) comprises a measuring indication unit (22) configured to indicate the leakage current.

6. The device (20) according to any one of claims 1-5, wherein the measurement circuit (24) comprises a surge counting circuit (34) configured to count surges.

7. The device (20) according to claim 6, wherein the surge counting circuit (34) and the leakage current measurement circuit (18) are connected across one or more TVS device (12).

8. The device (20) according to any one of claims 1-7, wherein the measurement circuit (24) comprises a conversion circuit (26), and wherein the conversion circuit (26) is configured to convert an alternating current, AC, to a direct current, DC, and supply said DC to the leakage current measurement circuit (18).

9. Method for protecting a measurement circuit (24), wherein the method comprises providing a device (20) comprising a suppression unit (10) and the measurement circuit (24), wherein the suppression unit (10) comprises at least one parallel connected protection branch (30) connected between a surge arrester (28) and ground, wherein the at least one protection branch (30) comprises at least one transient voltage suppression, TVS, device (12), and wherein the method comprises:
diverting (301) leakage current through the measurement circuit (24); and
bypassing (302) the measurement circuit (24) and leading surge current to ground, during a surge event to protect the measurement circuit (24).

10. The method according to claim 9, wherein the measurement circuit (24) comprises a leakage current measurement circuit (18), and wherein the method further comprises:
measuring (303) the leakage current.

11. The method according to claim 10, wherein the leakage current measuring circuit (18) comprises a measuring indication unit (22), and wherein the method further comprises indicating (304) the leakage current on the measuring indication unit (22).

12. The method according to any one of claims 9-11, wherein the measurement circuit comprises a surge counting circuit (34) and wherein the method further comprises counting (305) surges.

13. The method according to claim 12, wherein the surge counting circuit (34) and the leakage current measurement circuit (18) are connected across one or more TVS device (12).

14. The method according to any one of claims 9-13, wherein the measurement circuit (24) comprises a conversion circuit (26), and wherein the method further comprises converting an alternating current, AC, to a direct current, DC, and supplying said DC to the leakage current measurement circuit (18).

15. The method according to any one of claims 9-14, wherein the suppression unit (10) changes its behaviour from non-conductive to conductive during the surge event.
